# EUROPEAN PATENT APPLICATION

(11) **EP 1 961 834 A1**
(43) Date of publication of application: **27.08.2008**
(21) Application number: 07108414.9
(22) Date of filing: 17.05.2007
(51) Int. Cl.: C23C 14/34

(54) **Controlling magnetic leakage flux in sputtering targets containing magnetic and non-magnetic elements**

(30) Priority: 22.02.2007 US 709134
(71) Applicant: Heraeus, Inc., Chandler AZ 85226 (US)
(72) Inventor: Chung, Kyung H., Phoenix, AZ 85045 (US); Marx, Daniel R., Santa Barbara, CA 93019 (US); Kunkel, Bernd, Phoenix, AZ 85048 (US)
(74) Representative: Hill, Justin John

(57) **Abstract**

Various exemplary embodiments of the present invention relate to a method for controlling magnetic leakage flux in a sputtering target containing magnetic and non-magnetic elements. The method relates to selecting a particle size of at least one non-magnetic phase in a microstructure, where the particle size of the non-magnetic phase is greater than or equal to one micron. The non-magnetic phase is combined with at least one magnetic phase in the microstructure, where the magnetic phase is greater than or equal to 10 atomic percent and is greater than one micron in size. The selected particle size of the non-magnetic phase may increase the pass through flux (PTF) of the sputtering target. The magnetic phase and non-magnetic phases may be combined in the microstructure by hot isostatic pressing, sintering, spark plasma sintering, or vacuum hot pressing.

## Description

### BACKGROUND

### Field

The present invention is directed to methods for controlling magnetic flux in sputtering targets containing magnetic and non-magnetic elements. More particularly, the present invention relates to methods for controlling magnetic flux in sputtering targets containing magnetic and non-magnetic elements by controlling the size and distribution of the non-magnetic phase in the microstructure.

### Background

Sputtering processes are widely used for the deposition of thin films of material onto desired substrates. A typical sputtering system includes a source for generating an electron or ion beam, a target that comprises a material to be atomized (sputtered) and a substrate onto which the sputtered material is deposited. The process involves bombarding the target material with an electron or ion beam at an angle that causes the target material to be sputtered or eroded. The sputtered target material is deposited as a thin film or layer on the substrate. The target materials for sputtering process range from pure metals to ever more complicated alloys.

Magnetron sputtering involves the arrangement of permanent or electromagnets behind a target material (cathode), and applying a magnetic field to the target. The applied magnetic field transmits through the target and focuses a discharge plasma onto the front of the target. The amount of magnetic flux transmitted through the target is measureable and is often termed "Pass Through Flux" (PTF) or "Magnetic Leakage Flux" (MLF). The target front surface is atomized with subsequent deposition of the target atoms on top of an evolving thin film device positioned adjacent to the target,

Magnetron sputtering of magnetic target materials is very prevalent in the electronics industry, particularly in the fabrication of semiconductor and data storage devices. Due to the soft magnetic nature of magnetic target alloys, there is considerable shunting of the applied magnetic field in the bulk of the target. This in turn results in reduced target utilization due to focusing of the transmitted magnetic field in the erosion groove formed as a result of the shunting. This focusing effect is exacerbated with increasing material permeability (which corresponds to decreasing material PTF).

Reducing target material permeability promotes a less severe erosion profile which enhances target material utilization and subsequently contributes to a reduction in material cost. The presence of severe target erosion profiles also promotes a point source sputtering phenomena which can result in less than optimum deposited film thickness uniformity. Therefore, decreasing target material permeability has the added benefit of increasing deposited film thickness uniformity.

The PTF of a sputter target is defined as the ratio of transmitted magnetic field to applied magnetic field. A PTF value of 100% is indicative of a non-magnetic material where none of the applied field is shunted through the bulk of the target. The PTF of magnetic target materials is typically specified in the range of 0 to 100%, with the majority of commercially produced materials exhibiting values between 30 to 100%.

There are several different techniques for measuring PTF. One technique involves placing a 4.4 (+/-0.4) kilogauss bar magnet in contact on one side of the target material and monitoring the transmitted field using an axial Hall probe in contact on the other side of the target material. The maximum value of the magnetic field transmitted through the bulk of the target divided by the applied field strength in the absence of the target between the magnet and probe (maintained at the same distance apart as when the target was between them) is defined as the PTF. PTF can be expressed as either a fraction or a percent.

Another technique for measuring PTF involves using a horseshoe magnet and a transverse Hall probe. The PTF values measured using different and probe arrangements are found to exhibit good linear correlation for the values of magnet field strength typically utilized in the industry. The PTF measurement techniques are constructed to approximate the applied magnetic flux occurring in an actual magnetron sputtering machine. Therefore, PTF measurements have direct applicability to a target material's performance during magnetron

Magnetic material PTF and permeability are not mutually exclusive. Rather, there is a very strong inverse correlation between PTF and maximum permeability of magnetic materials. Values of material magnetic permeability can be very precisely determined by using vibrating-sample-magnetometer (VSM) techniques in accordance with ASTM Standard A 894-89.

PTF depends upon sputtering target thickness and material characteristics of the sputtering target. The maximum target thickness is limited by the magnetic characteristics of a material. Because of the thickness characteristics of current targets, the targets must be replaced frequently in a sputtering process. In addition, the sputtering productivity is also limited by the compatibility of the target PTF with a cathode. Particular magnetron cathodes can have greater sputtering productivity for target materials with a particular range of PTF.

Accordingly, what is needed are improved methods for controlling magnetic flux in sputtering targets containing magnetic and non-magnetic elements. What is further needed are methods for controlling the microstructure in order to increase the PTF and fabricate thicker targets so as to allow for improved sputtering productivity by reducing system down time for target replacement. What is additionally needed is a method for tailoring PTF to a predetermined cathode to improve sputtering productivity.

### SUMMARY

The various embodiments of the present invention address the above-described deficiencies of typical systems and methods for controlling magnetic flux in sputtering targets.

Various exemplary embodiments of the present invention relate to a method for controlling magnetic leakage flux in a sputtering target containing magnetic and non-magnetic elements. The method relates to selecting a particle size of at least one non-magnetic phase in a microstructure, where the particle size of the non-magnetic phase is greater than or equal to one micron. The particle size of the non-magnetic phase may be selected to be greater than or equal to 10 microns. At least one non-magnetic phase is combined with at least one magnetic phase in the microsn-ucture, where the at least one magnetic phase is greater than or equal to 10 atomic percent, and where the at least one magnetic phase in the microstructure is greater than one micron in size. The selected particle size of the at least one non-magnetic phase decreases the diffusion between the at least one magnetic phase and the at least one non-magnetic phase in the microstructure. The particle size of the at least non-magnetic phase is selected so as to increase the pass through flux (PTF) of the sputtering target by decreasing the diffusion between the at least one magnetic phase and the at least one non-magnetic phase in the microstructure. The at least one magnetic phase and the at least one non-magnetic phase may be combined in the microstructure by hot isostatic pressing, sintering, spark plasma sintering, or vacuum hot pressing.

In various exemplary embodiments, the sputtering target may be a Co-Cr-Pt target. In certain embodiments, the sputtering target is further alloyed with an oxide, such as TiO₂, SiO₂, or any other suitable oxide. In various exemplary embodiments of the present invention, the magnetic leakage flux of the target can be varied as a function of grain size of the Pt phase. For example, coarse platinum (Pt) particles may be selected so as to decrease the diffusion between the platinum (Pt) particle and the cobalt (Co) containing particles, wherein a larger platinum (Pt) region in a composite material is maintained to increase pass through flux (PTF). For example, the coarse platinum (Pt) particle may be controlled to be greater than or equal to one micron in size, and may be preferably be greater than or equal to 10 microns in size. Although, the at least one non-magnetic phase in a microstructure may be controlled to similar ranges in size. In various exemplary embodiments, the size, or distribution, or a combination thereof of the non-magnetic phases in the microstructure are varied to adjust the magnetic leakage flux of the target.

Various advantages of the exemplary embodiments of the present invention include, but are not limited to, controlling the PTF of a sputtering target. In the plasma vapor deposition (PVD) or sputtering systems, the plasma is confined close to the sputtering surface by a strong magnetic field (a magnetron cathode), thus promoting an increased sputtering rate. The magnetic field source is located behind the target, and the magnetic has to pass through cathode structural materials and the sputtering target material with sufficient strength to confine the plasma close to the target surface. Because the PTF depends on the target thickness and target characteristics, the maximum target thickness is limited by the magnetic characteristics of the material. By controlling the microstructure in order to increase PTF, thicker targets can be produced, which can result improved sputtering productivity by reducing system down time for targets replacement. Additionally, controlling the microstructure of a composition to increase PTF may also minimize typical problems associated with particulate generation in Co-Cr-Pt-Oxide alloys (e.g., Cr-Co-Pt-SiO₂, Cr-Co-Pt-TiO₂, etc.) where nonuniform thickness and distribution of a sputtering target surface can occur. Accordingly, it is advantageous to tailor a PTF of a target to a particular cathode to improve sputtering productivity, where a target with a tailored PTF improves the uniformity and thickness characteristics of the target.

As a result of the high temperature consolidation process, inter-diffusion between the components of a powder blend for a Co-Cr-Pt-Oxide alloy (e.g., Cr-Co-Pt-SiO₂, Cr-Co-Pt-TiO₂, etc.), magnetically susceptible phases are developed, thus providing a shunting of the applied magnetic field and accordingly lowering the PTF. In various exemplary embodiments of the present invention, selecting the particle size of platinum (Pt) and CoCr master alloy minimizes the amount of the magnetically detrimental phases that may lower the PTF. For a given consolidation process, with a suitable selection of powders, one can "dial in" a desired PTF level for a sputtering target. Accordingly, the advantages of the various exemplary embodiments of the present invention allow tailoring a PTF to match the sputtering cathode's optimum requirements to provide an ability to better meet a user's requirements. Additionally, an advantage of the present invention is that materials may be selected for sputtering targets such that they have a desired predetermined PTF or a controlled PTF range.

It is understood that other embodiments of the present invention will become readily apparent to those skilled in the art from the following detailed description, wherein it is shown and described only various embodiments of the invention by way of illustration. As will be realized, the invention is capable of other and different embodiments and its several details are capable of modification in various other respects, all without departing from the spirit and scope of the present invention. Accordingly, the drawings and detailed description are to be regarded as illustrative in nature and not as restrictive.

### BRIEF DESCRIPTION OF THE DRAWINGS

Referring now to the drawings in which like reference numbers represent corresponding parts throughout:

FIG. 1 is an SEM image of an exemplary Co-Cr-Pt-TiO₂ powder composite material depicting four separate measurement areas (i.e., spectrum 1, spectrum 2, spectrum 3, and spectrum 4) the areas having various magnetic and non-magnetic phases in the microstructure, according to various exemplary embodiments of the present invention;

FIG. 2 is an Energy Dispersive X-ray Spectroscopy (EDS) graph depicting the presence of the non-magnetic Pt phase in the microstructure of the spectrum 1 area of the Co-Cr-Pt-TiO₂ powder composite in FIG. 1 according to various exemplary embodiments of the present invention;

FIG. 3 is an EDS graph depicting the presence of Co and Cr phases in the microstructure of the spectrum 2 area of the Co-Cr-Pt-TiO₂ powder composite in FIG. 1 according to various exemplary embodiments of the present invention;

FIG. 4 is an EDS graph depicting the Co phases in the microstructure of the spectrum 3 area of the Co-Cr-Pt-TiO₂ powder composite in FIG. 1 according to various exemplary embodiments of the present invention;

FIG. 5 is an EDS graph depicting Co and Pt phases in the microstructure of the spectrum 4 measuring area of the Co-Cr-Pt-TiO₂ powder composite in FIG. 1 according to various exemplary embodiments of the present invention;

FIG. 6A is an SEM image of a Co-Cr-Pt-TiO₂ powder composite material having a PTF of 81% according to various exemplary embodiments of the present invention;

FIG. 6B is an SEM image of a Co-Cr-Pt-TiO₂ powder composite material having a PTF of 68% according to various exemplary embodiments of the present invention;

FIG. 7 is a chart illustrating the particle size versus the volume fraction of the Co-Cr-Pt-TiO₂ powder composite materials of FIGS. 6A and 6B according to various embodiments of the present invention;

FIG. 8A is an EDS spectrum graph of the powder composite material of FIG. 6A, wherein the spectrum graph indicates lower content of Co in the Pt particles, thus less diffusion between the particles of the microstructure, according to various exemplary embodiments of the present invention;

FIG. 8B is an EDS spectrum graph of the powder composite material of FIG. 6B, according to various exemplary embodiments of the present invention;

FIG. 9A is an SEM image of a Co-Cr-Pt-SiO₂ powder composite material processed with a Hot Isostatic Pressing (HIP) temperature of 927° C to achieve a PTF of 68%, according to various exemplary embodiments of the present invention;

FIG. 9B is an SEM image of a Co-Cr-Pt-SiO₂ powder composite material processed with a Hot Isostatic Pressing (HIP) temperature of 1300° C to achieve a PTF of 54%, according to various exemplary embodiments of the present invention;

FIG. 10A is an SEM image of a Co-Cr-PT-TiO₂ powder composite material having a PTF of 64%, wherein an Co-Cr alloy powder is used, according to various exemplary embodiments of the present invention;

FIG. 10B is an SEM image of a Co-Cr-Pt-TiO₂ powder composite material having a PTF of 52%, according to various exemplary embodiments of the present invention; and

FIG. 11 is the effects of increasing the atomic percent of Cr content in a Co alloy material, such as Co-Cr-Pt-TiO₂, according to various exemplary embodiments of the present invention.

### DETAILED DESCRIPTION

The detailed description set forth below in connection with the appended drawings is intended as a description of various embodiments of the invention and is not intended to represent the only embodiments in which the invention may be practiced. The detailed description includes specific details for the purpose of providing a thorough understanding of the invention. However, it will be it will be apparent to those skilled in the art that the invention may be practiced without these specific details.

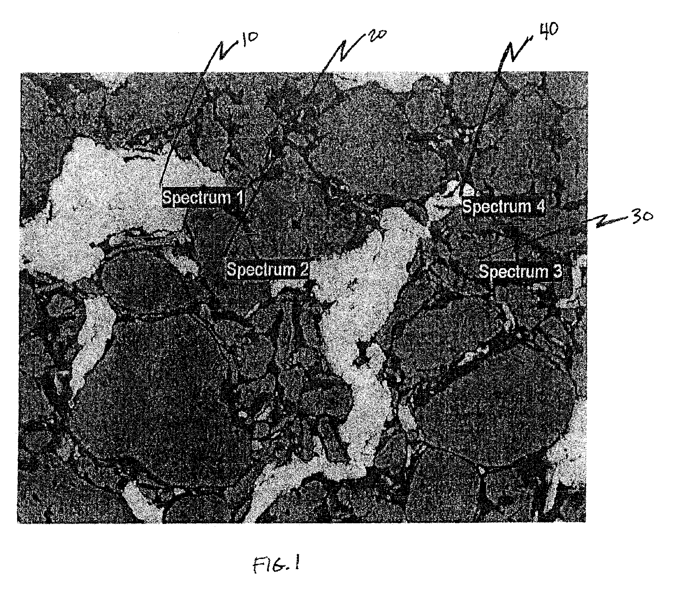

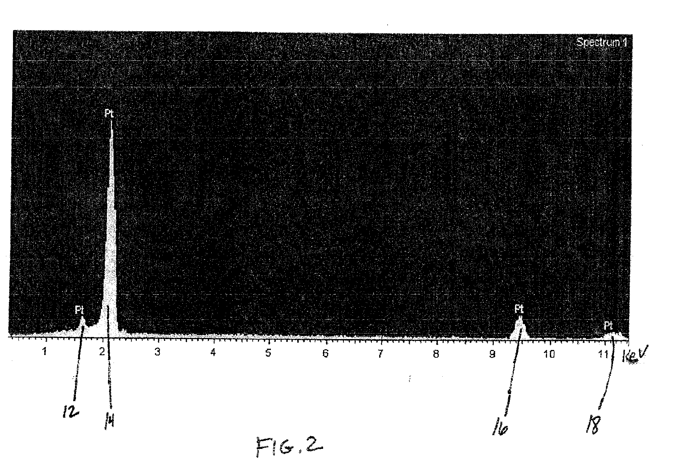

FIGS. 1-5 illustrate various exemplary phases of a Co-Cr-Pt-TiO₂ powder composite material, where the atomic percent of elements and phases have been selected and arranged to achieve a desired PTF. The various phases may co-exist with each other (e.g., as illustrated by the magnetic and non-magnotic phases of the microstructure illustrated in FIG. 1), or may be separate (e.g., the non-magnetic Pt phase of FIG. 2), depending on the area of the microstructure of the Co-Cr-Pt-TiO₂ powder composite material. These phases, which may be magnetic or non-magnetic, may be adjusted in order to increase or decrease the desired PTF. For example, the particle size and distribution of the particles of the microstructure may be selected so as to control diffusion of the particles of the microstructure. Thus, it is by controlling the particle size of elements and the arrangement of the magnetic and non-magnetic phases that a desired PTF in sputtering targets may be produced.

FIG. 1 is an SEM image of an exemplary Co-Cr-Pt- TiO₂ powder composite material depicting different areas (i.e., spectrum 1 to spectrum 4). For example, area 10 (spectrum 1), area 20 (spectrum 2), area 30 (spectrum 3), and area 40 (spectrum 4) illustrate the selection and distribution of different elements and phases in order to achieve a desired PTF in a Co-Cr-Pt-TiO₂ composite. These areas (i.e., areas 10, 20, 30, and 40) may have magnetic or non-magnetic phases, and may be comprised of either a single element or multiple elements. The phases and compositions of the areas 10, 20, 30 and 40 are more specifically depicted in the EDS spectrums of FIGS. 2-5, and are described below. In addition, exemplary atomic weight percentage values for each for area (spectrum 1 -spectrum 4) for an exemplary composite of Co-Cr-Pt-TiO₂ are indicated in Table 1 below:

**TABLE 1: Atomic Weight Percent by Element for Exemplary Co-Cr-Pt-TiO₂**

| **Spectrum** | **O** | **Cr** | **Co** | **Pt** |
|---|---|---|---|---|
| Spectrum 1 | -- | -- | -- | 100.00 |
| Spectrum 2 | -- | 25.21 | 74.79 | -- |
| Spectrum 3 | -- | -- | 100.00 | -- |
| Spectrum 4 | -- | -- | 10.76 | 89.24 |

FIG. 2 is an Energy Dispersive X-ray Spectroscopy (EDS) indicating the microstructure of the spectrum 1 area of FIG. 1 (i.e., area 10) according to various exemplary embodiments of the present invention. Peaks 12, 14, 16, and 18 indicate that, of the elements of the exemplary Co-Cr-Pt-TiO₂ composite, the Pt element of the composite has been positioned in the spectrum 1 area (e.g., area 10 of FIG. 1). Table 1 also indicated that an 100 atomic weight percent of Pt has been selected to be positioned in area 10. Thus, a non-magnetic Pt phase of the Co-Cr-Pt-TiO₂ composite is present in area 10 of FIG- 1.

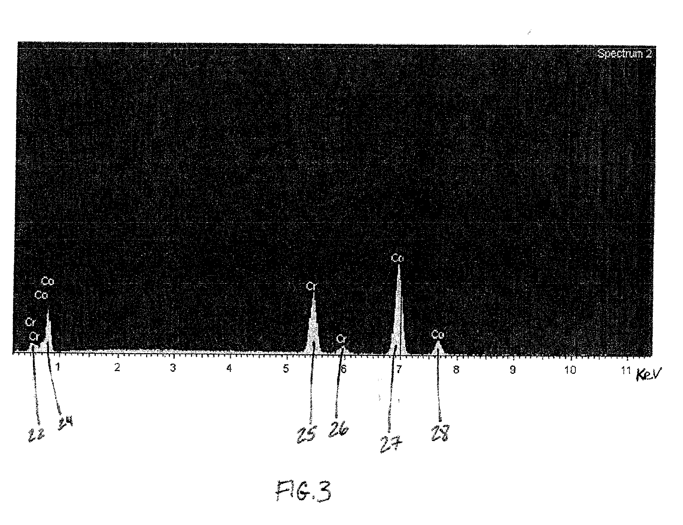

Turning to FIG. 3, peaks 22, 24, 25, 26, 27, and 28 are depicted in an EDS graph indicating the selection and placement of Co and Cr phases in the microstructure at spectrum 2 (i.e., area 20 of FIG. 1) of the exemplary Co-Cr-Pt-TiO₂ composite. Peaks 22, 25, and 26 are representative of Cr, while peaks 24, 27, and 28 are representative of Co in the microstructure. As indicated above in Table 1, exemplary spectrum 2 has been selected to have a Cr content of about 25.21 atomic percent, and a Co content of about 74.79 atomic percent. Thus, the Cr and Co phases of the Co-Cr-Pt-TiO₂ powder composite, given their composition, are in a non-magnetic phase. Again, FIG. 3 illustrates that a particular area (e.g., area 20) of the microstructure of FIG. 1 may have particular characteristics (e.g., Co and Cr elements of particular atomic percent in non-magnetic phase) that may co-exist within the overall microstructure depicted in FIG. 1.

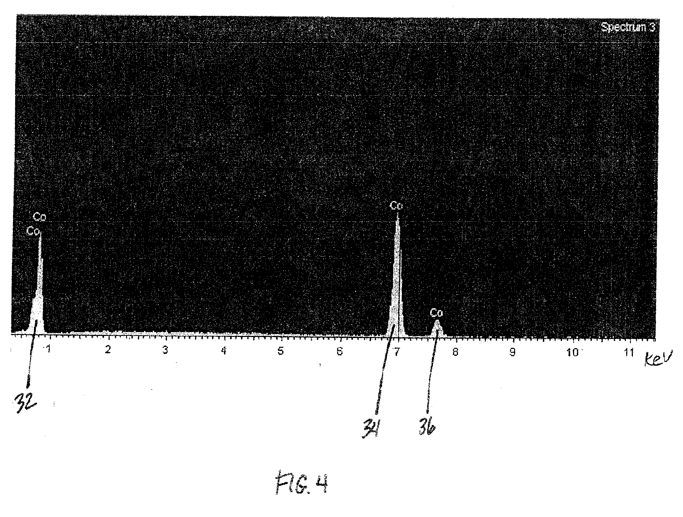

FIG. 4 is an EDS graph indicating that Co phases have been positioned in the microstructure at spectrum 3 (area 30) of FIG. 1. Peaks 32, 34, and 36 illustrate Co phases in the exemplary Co-Cr-Pt-TiO₂ powder composite. As illustrated in FIG. 4, and indicated above in Table 1, the magnetic Co phase has been selected to be about 100 atomic percent in spectrum 3, with no other phases in this area. Therefore, in area 30 depicted in FIG. 1, the Co phase is a magnetic phase portion of the overall microstructure of the Co-Cr-Pt-TiO₂ powder composite, and co-exists with other phases in different areas of the microstructure.

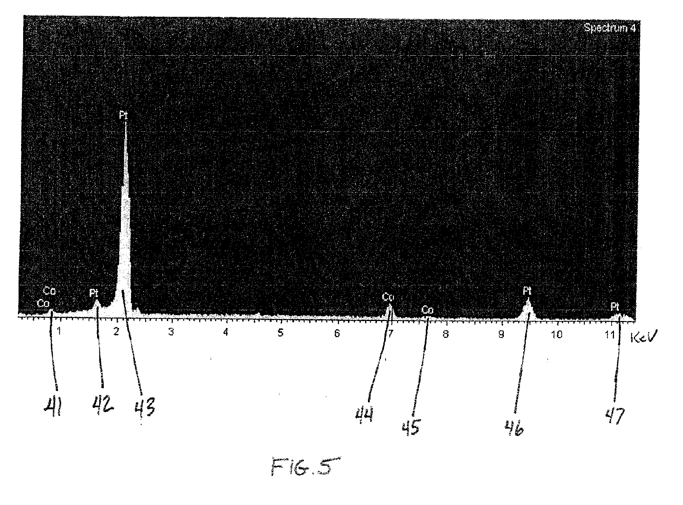

FIG. 5 is an EDS graph indicating the Co and Pt phases selected for the microstructure at spectrum 4 (area 40) of FIG. 1 of the exemplary Co-Cr-Pt-TiO₂ powder composite, with peaks 41, 42, 43, 44, 45, 46, and 47 representing the Co and Pt phases. More specifically, peaks 41, 44, and 45 indicate the Co phases, and peaks 42, 43, 46, and 47 indicate the Pt phases. As indicated in Table 1, Co with an atomic percent of about 10.76 has been selected, and Pt with atomic percent of about 89.24 has been selected for this area. Accordingly, the Co and Pt phases present in this area of the microstructure are non-magnetic. Thus, FIG. 5 illustrates that a particular area (e.g., area 40) of the microstructure of FIG. 1 may have a particular selection of characteristics that may co-exist within the overall microstructure depicted in FIG. 1.

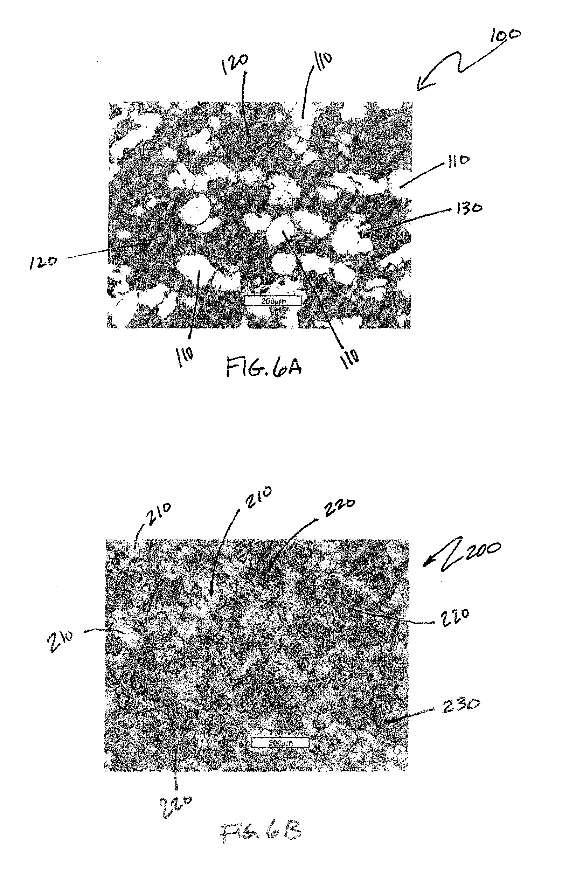

FIGS. 6A and 6B illustrate exemplary Co-Cr-Pt-TiO₂ powder composites that are processed using the same processing parameters according to various exemplary embodiments of the present invention. More specifically, FIG. 6A illustrates an SEM image of a Co-Cr-Pt-TiO₂ powder composite material 100 selected to have coarse Pt particles. Coarse particles may be particles with a size greater than one micron. For example, coarse particles may be preferably greater than or equal to 10 µm in size, greater than or equal to 20 µm, or may be 50-60 µm, 60-70 µm, or 70-80 µm in size. With this particular selection, the exemplary powder composite material 100 has a PTF of about 81%. Area 110, which is lightly shaded or white in the SEM image of FIG. 6A, depicts an exemplary region of Pt particles. Area 120, which is darkly shaded in the SEM image compared to area 110, depicts an exemplary region of Co or Cr particles, or a combination of Co and Cr particles. Area 130, which is darkly shaded in comparison to area 120, depicts an exemplary region of TiO₂ particles.

FIG. 6B illustrates an SEM image of a Co-Cr-Pt-TiO₂ powder composite material 200 having a PTF of 68% according to at least one exemplary embodiment of the present invention. Area 210, which is lightly shaded or white in the SEM image of FIG. 6B, depicts an exemplary region of Pt particles. Area 220, which is darkly shaded in the SEM image compared to area 210, depicts an exemplary region of Co or Cr particles, or a combination of Co and Cr particles. Area 230, which is darkly shaded in comparison to area 220, depicts an exemplary region of TiO₂ particles.

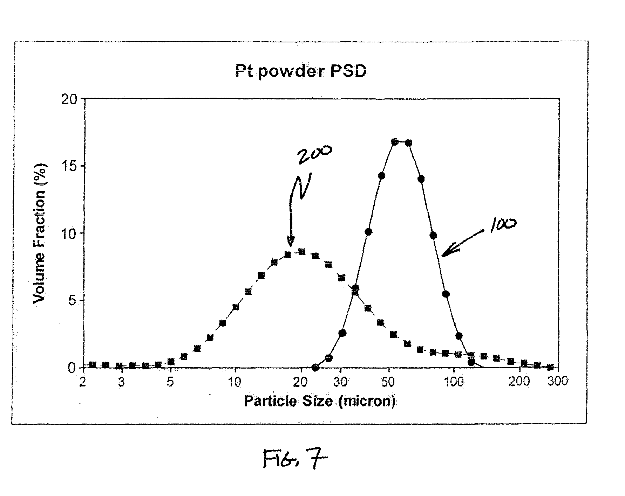

The raw materials of the exemplary composites illustrated in FIGS. 6A and 6B are Co powder, Co-Cr alloy powder, Pt powder and TiO₂. In this first example, these raw materials for the composites are processed in the same manner, including the consolidation process. However, the initial particle size of Pt is varied. In the exemplary embodiment illustrated in FIG. 6A, coarser Pt particles are used in powder composite material 100. Coarse particles may have a size greater than one micron, and may preferably range from 20 µm to 100 µm. FIG. 7 illustrates the Pt powder particle size distribution. FIG. 7 details the increased size (in microns) and volume faction (a percentage value) of Pt for powder composite material 100 compared to the Pt for powder composite material 200. As indicated in FIG. 7, coarse particles of 50 to 70 µm in size with a volume fraction between 10-20% (see, e.g., material 100 of FIG. 7), yield a different microstructure than when finer Pt particles (e.g., less than 20 µm with a volume fraction of less than or equal to 10%) as shown, in material 200.

For example, exemplary area 110, or other similar areas in FIG. 6A with Pt particles, is much larger in size than that of exemplary area 210 of FIG. 6B. Accordingly, the inter-diffusion between the coarse Pt particles (e.g., the Pt particles of area 110) and the Co-containing particles (e.g., the Co-containing particles of area 120) is limited. Thus, a larger, pure-Pt region (e.g., area 110 of FIG. 6A) may be maintained, which is preferable for achieving a suitable channel for the magnetic field and for increasing PTF. For example, as shown in FIG. 6B, the Pt particles have increased diffusion with the Co and Cr particles, thus minimizing the suitable channels for magnetic field and reducing the overall PTF (e.g., the PTF is 68% for FIG. 6B, whereas the PTF is 81 % in FIG. 6A, where there is less diffusion of the Pt particles with the Co and Cr particles).

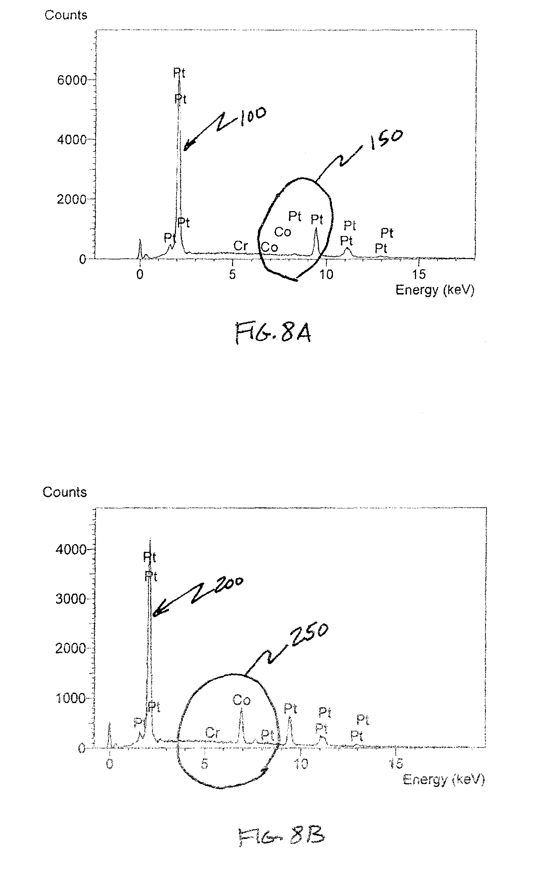

FIGS. 8A and 8B are Energy Dispersive X-ray Spectroscopy (EDS) spectrum graphs of the powder composite material of FIGS. 6A and 6B, respectively. More specifically, FIG. 8A illustrates an EDS spectrum graph of powder composite material 100 of FIG. 6A, and FIG. 8B illustrates an EDS spectrum graph of powder composite material 200 of FIG. 6B, according to various exemplary embodiments of the present invention. As noted above, the comparative selection of different particle sizes and arrangement of phases between material 100 and material 200 yielded different PTF values. Compared to area 250 of FIG. 8B, area 150 of the EDS spectrum graph of FIG. 8A indicates lower content of Co in the Pt particles powder material composite 100, and thus less diffusion between the Co particles and the Pt particles in powder composite material 100. Again, by using coarse Pt particles in powder composite material 100, for example, inter-diffusion between the Pt and CO particles is minimized, and a larger area of pure-Pt region (e.g., area 110 of FIG. 6A) may be maintained. The minimized inter-diffusion of Pt particles with Co and/or Cr promotes a suitable channel for the magnetic field and for increasing PTF.

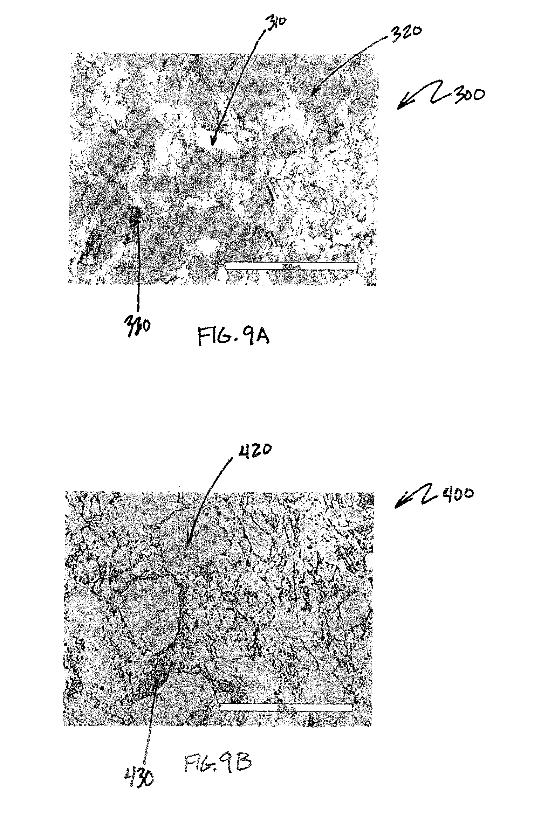

FIGS. 9A and 9B depict SFM images of Co-Cr-Pt-SiO₂ powder composite matem-ds processed by Hot Isostatic Pressing (HIP) according to various exemplary embodiments of the present invention. More specifically, FIG. 9A illustrates an SEM image of a Co-Cr-Pt-SiO₂ powder composite material 300 processed with a Hot Isostatic Pressing (HIP) of temperature of 927° C to achieve a PTF of 68%. In FIG. 9A, area 310, which is lightly shaded or white in the SEM image of FIG. 9A, depicts Pt particles. Area 320, which is darkly shaded in the SEM image compared to area 310, depicts Co or Cr particles, or a combination of Co and Cr particles. Area 330, which is darkly shaded in comparison to area 320, depicts SiO₂ particles.

FIG. 9B is an SEM image of a Co-Cr-Pt-SiO₂ powder composite material 400 processed with a HIP temperature of 1300° C to achieve a PTF of 54%. The Pt particles in FIG. 9B are not as distinct as they are in FIG. 9A (e.g., such as in area 310). In FIG. 9B, the Pt particles are diffused with the Co and Cr particles in area 420. Area 430 in FIG. 9B which is darkly shaded in comparison to area 420, depicts SiO₂ particles.

Powder composite materials 300 and 400 illustrated in FIGS. 9A and 9B are comprised of the same raw materials, such as Co powder, Co-Cr alloy powder, Pt powder, and SiO₂. Additionally, powder composite materials 300 and 400 are processed under similar conditions, differing only with respect to the HIP temperature utilized (i.e., 927° C for powder composite material 300 of FIG. 9A, and 1300° C for powder composite material 400 of FIG. 9B). Because of the different HIP temperature, powder composite material 400 of FIG. 9B shows minimal contrast difference by region in the back-scattered SEM image. The minimal contrast is indicative of the samples (illustrated in FIGS. 9A and 9B) having the same chemical composition. Additionally, powder composite material 300 illustrated in FIG. 9A shows a bright region (e.g., area 310), in which a substantial amount of non-magnetic Pt is present. The Co-Cr alloy phases (e.g., area 320 of FIG. 9A) does not show substantial diffusion. Comparatively, FIG. 9B illustrates diffusion of the Pt particles into the Co-Cr alloy phases (i.e., regions such as area 310 are not visible in material 400 of FIG. 9B). Accordingly, if the increased PTF Co-Cr alloy phase is maintained (i.e., minimizing the diffusion of the Co-Cr alloy with the Pt particles), suitable channels for the magnetic field may be maintained, accordingly providing an increased PTF. The combined effects of the Co-Cr alloyed phase and the substantial Pt phase allows powder composite material 300 of FIG. 9A to have an increased PTF.

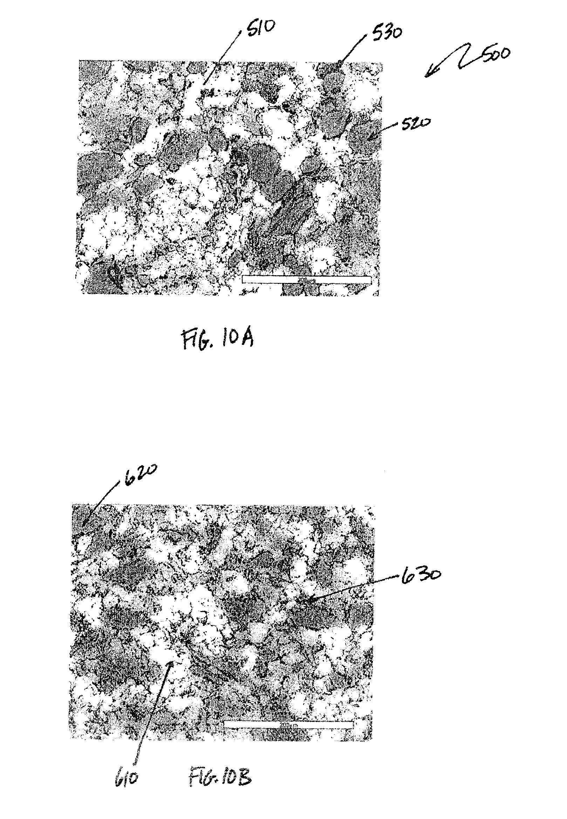

FIGS. 10A and 10B are SEM images of Co-Cr-PT-TiO₂ composite material according to various exemplary embodiments of the present invention. Composition 500 of FIG. 10A and composition 600 of FIG. 10B are both comprised of Co-Cr-Pt-TiO₂. The raw materials of composition 500 of exemplary FIG. 10A are Co powder, Co-Cr powder, Pt powder, and TiO₂, and the raw materials of composition 600 of Co powder, Cr powder, Pt powder and TiO₂. Thus, the difference between exemplary composition 500 and exemplary composition 600 is the presence ofCo-Cr alloyed powder in composition 500.

Composition 500 may have area 510, which is lightly shaded or white in the SEM image of FIG. 10A, that depicts Pt particles. Area 520, which is darkly shaded in the SEM image compared to area 310, depicts Co or Cr particles, or a combination of Co and Cr particles. Area 530, which is darkly shaded in comparison to area 520, depicts TiO₂ particles. Composition 600 of FIG. 10B may have area 610, which illustrates Pt particles. Area 620 may depict Co or Cr particles, or a combination of Co and Cr particles. Area 630, which is darkly shaded in comparison to area 620, depicts TiO₂ particles.

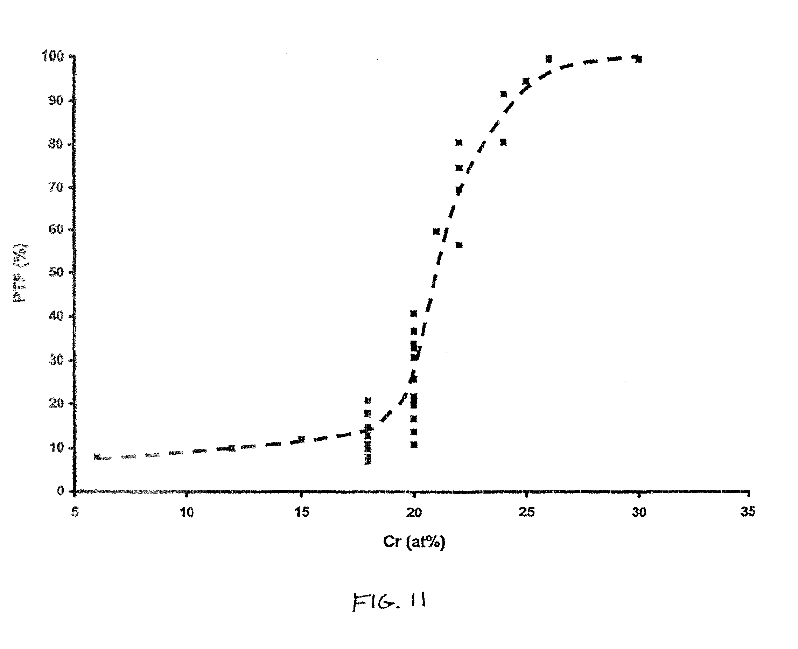

Composition 500 of FIG. 10A is comprised of the Co-Cr alloyed powder, while composition 600 of FIG. 10B is comprised of elemental Co powder and elemental Cr powder. As the Cr content in the Co alloy exceeds 20 atomic percent, as illustrated in FIG. 11, the PTF substantially increases. For example, composition 500 of FIG. 10A has a PTF of 64%, while composition 600 of FIG. 10B has a PTF of 52%. Accordingly, the selection and use of Co-Cr alloy powder incorporated in composition 500, or other compositions for sputter targets, increases the overall PTF of the target. In comparison, if elemental Co powder is increasingly added to a Co-Cr-Pt-TiO₂ composition, the PTF of the sputter target will typically decrease.

In the examples described above, by distributing and controlling non-magnetic (e.g., Pt) or increased PTF phases (e.g., the Co-Cr alloy phase) in the Co-based targets, the PTF may accordingly be controlled or increased as desired. In order to facilitate the control or increase in PTF, the raw materials of the composite material may be strategically selected to achieve the desired effects, and the process conditions may be controlled to maintain the PTF "boosting phases" in the microstructure. Accordingly, the microstructure may be a mixture of the regions with different chemically distinctive compositions. For example, a chemically distinctive composition may have 10 atomic percent or more difference in the magnetic elements (e.g., Co, Fe, etc.) by regions. In addition, the region size may be greater than one micron.

In at least one of the various examples described above, Hot isostatic Pressing (HIP) processes and temperatures are described for combining elements to form a microstructure. However, normal sintering, Spark Plasma Sintering (SPS), vacuum hot press, or other suitable processing methods and temperatures to facilitate these processing method may be used to combine the raw materials (e.g., Co powder, Cr powder, Co-Cr alloy powder, Pt powder, SiO₂, TiO₂, etc.) to form a composition (e.g., Co-Cr-Pt-TiO₂, Co-Cr-Pt-SiO₂, etc.).

The detailed description set forth below in connection with the appended drawings is intended as a description of various embodiments of the invention and is not intended to represent the only embodiments in which the invention may be practiced. The detailed description includes specific details for the purpose of providing a thorough understanding of the invention. However, it will be apparent to those skilled in the art that the invention may be practiced without these specific details. In some instances, well known structures and components are shown in block diagram form in order to avoid obscuring the concepts of the invention.

It is understood that the specific order or hierarchy of steps in the processes disclosed is an example of exemplary approaches. Based upon design preferences, it is understood that the specific order or hierarchy of steps in the processes may be rearranged while remaining within the scope of the present disclosure. The accompanying method claims present elements of the various steps in a sample order, and are not meant to be limited to the specific order or hierarchy presented.

The previous description is provided to enable any person skilled in the art to practice the various embodiments described herein. Various modifications to these embodiments will be readily apparent to those skilled in the art, and the generic principles defined herein may be applied to other embodiments. Thus, the claims are not intended to be limited to the embodiments shown herein, but is to be accorded the full scope consistent with the language claims, wherein reference to an element in the singular is not intended to mean "one and only one" unless specifically so stated, but rather "one or more." All structural and functional equivalents to the elements of the various embodiments described throughout this disclosure that are known or later come to be known to those of ordinary skill in the art are expressly incorporated herein by reference and are to be encompassed by the claims. Moreover, nothing disclosed is intended to be dedicated co the public regardless of whether such disclosure is explicitly recited in the claims. No claim element is to be construed under the provisions of 35 U.S.C. §112, sixth paragraph, unless the element is expressly recited using the phrase "means for" or, in the case of a method claim, the element is recited using the phrase "step for."

## Claims

1. A method for controlling magnetic leakage flux in a sputtering target containing magnetic and non-magnetic elements, comprising:
selecting a particle size of at least one non-magnetic phase in a microstructure, wherein the particle size of the non-magnetic phase is greater than or equal to one micron; and
combining the at least one non-magnetic phase with at least one magnetic phase in the microstructure, wherein the at least one magnetic phase is greater than or equal to 10 atomic percent, wherein the at least one magnetic phase in the microstructure is greater than one micron in size, and wherein the selected particle size of the at least one non-magnetic phase decreases the diffusion between the at least one magnetic phase and the at least one non-magnetic phase in the microstructure.

2. The method of claim 1, wherein the particle size of the non-magnetic phase is selected to be greater than or equal to 10 microns.

3. The method of claim 1, wherein the particle size of the at least non-magnetic phase is selected so as to increase the pass through flux (PTF) of the sputtering target by decreasing the diffusion between the at least one magnetic phase and the at least one non-magnetic phase in the microstructure.

4. The method of claim 1, wherein the at least one magnetic phase and the at least one non-magnetic phase are combined in the microstructure by hot isostatic pressing, sintering, spark plasma sintering, or vacuum hot pressing.
